# EUROPEAN PATENT SPECIFICATION

(11) **EP 4 154 308 B1**
(45) Date of publication and mention of the grant of the patent: **24.06.2026**
(21) Application number: 20735513.2
(22) Date of filing: 25.06.2020
(51) Int. Cl.: H10W 20/00, H10W 20/20, H10W 20/43, H10W 15/00, H10W 20/41

(54) **SEMICONDUCTOR DEVICE, SEMICONDUCTOR DIE, AND METHOD OF MANUFACTURING A SEMICONDUCTOR DEVICE**
HALBLEITERBAUELEMENT, HALBLEITERCHIP UND VERFAHREN ZUR HERSTELLUNG EINES HALBLEITERBAUELEMENTS
DISPOSITIF À SEMI-CONDUCTEUR, PUCE SEMI-CONDUCTRICE ET PROCÉDÉ POUR LA FABRICATION D'UN DISPOSITIF À SEMI-CONDUCTEUR

(43) Date of publication of application: 29.03.2023
(73) Proprietor: Huawei Technologies Co., Ltd., Longgang District, Shenzhen, Guangdong 518129 (CN)
(72) Inventor: BADAROGLU, Mustafa, 80992 Munich (DE)
(74) Representative: Grünecker Patent- und Rechtsanwälte PartG mbB
(86) International application number: PCT/EP2020/067774
(87) International publication number: WO 2021/259479

(56) References cited:
- EP-A1- 3 454 366
- EP-A1- 3 671 825
- US-A1- 2018 151 494
- US-A1- 2018 294 267
- US-A1- 2018 374 791
- US-A1- 2019 035 785
- US-A1- 2019 165 178
- US-A1- 2020 105 603
- US-A1- 2020 135 578
- US-A1- 2020 135 634
- US-A1- 2020 411 436

## Description

### TECHNICAL FIELD

The present disclosure relates generally to semiconductor technology, and more specifically, to a semiconductor device, a semiconductor die, and a method of manufacturing a semiconductor device.

### BACKGROUND

Increasing advancements in semiconductor technology are leading to reduction in physical footprints of semiconductor devices. Semiconductor scaling and miniaturization is progressing rapidly to continually increase the number of transistors that can be integrated on a given semiconductor chip. Despite such advancements, semiconductor scaling is facing newer challenges as single digit nanometre semiconductor devices are being developed.

Nowadays, advancements are being made to reduce cell height of advanced semiconductor devices (that already have a size of the order of a couple of nanometres) as scaling of ground rules such as metal pitches and gate pitch are proving insufficient to reduce digital block area. Developments are being made to shrink space consumed by power rails of the semiconductor devices, as well as space between P-type metal-oxide-semiconductor (PMOS) and N-type metal-oxide-semiconductor (NMOS). Scaling power rail width would increase resistance of the power rail and lead to considerable IR drop in the power rail, which negatively impacts performance of the power rail. Presently, power rail estate is being reduced by introducing buried power rails, where routing space allocated to the power rail can be used for other routing while meeting voltage IR-drop requirements of the power rail by designing a high-aspect ratio power rail.
US 2019/035785 A1 discloses a device including a fin disposed on a substrate. The fin includes an active device. A plurality of isolation features are disposed on the substrate and below the active device. An interconnect is disposed on the substrate and between the plurality of isolation features such that the interconnect is below a topmost surface of the plurality of isolation features. The interconnect is electrically coupled to the active device. In some such examples, a gate stack of the active device is disposed over a channel region of the active device and is electrically coupled to the interconnect. In some such examples, a source/drain contact is electrically coupled to a source/drain region of the active device, and the source/drain contact is electrically coupled to the interconnect. EP 3 671 825 A1 discloses an integrated circuit chip having fin-based active devices in the front end of line, and in particular to the electrical connection between a contact area on a semiconductor fin, such as an epitaxially grown source or drain contact area of a transistor, and a buried interconnect rail. According to the invention, the connection is realized without the intervention of a metallization level formed above the active devices in the IC. Instead, an interconnect via is produced between the rail and a lateral portion of the contact area, wherein said lateral portion is directly contacted by a sidewall of the interconnect via. The invention is equally related to a method for producing the interconnect via. US 2018/151494 A1 discloses a memory bit cell, a first word line, a pair of metal islands and a pair of connection metal lines. The first word line is disposed in a first metal layer and is electrically coupled to the memory bit cell. The pair of metal islands are disposed in the first metal layer at opposite sides of the word line and are electrically coupled to a power supply. The pair of connection metal lines are disposed in a second metal layer and are configured to electrically couple the metal islands to the memory bit cell respectively. US 2019/165178 A1 discloses fin field-effect transistors (finFETs) to provide an example, having one or more metal rail conductors and various methods for fabricating these non-planar semiconductor devices. In some situations, the one or more metal rail conductors can be electrically connected to gate, source, and/or drain regions of these various non-planar semiconductor devices. In these situations, the one or more metal rail conductors can be utilized to electrically connect the gate, the source, and/or the drain regions of various non-planar semiconductor devices to other gate, source, and/or drain regions of various non-planar semiconductor devices and/or other semiconductor devices. However, in other situations, the one or more metal rail conductors can be isolated from the gate, the source, and/or the drain regions these various non-planar semiconductor devices. This isolation prevents electrical connection between the one or more metal rail conductors and the gate, the source, and/or the drain regions these various non-planar semiconductor devices. US 2020/135634 A1 discloses a method of etching a semiconductor substrate to form two semiconductor strips. The two semiconductor strips are over a bulk portion of the semiconductor substrate. The method further includes etching the bulk portion to form a trench in the bulk portion of the semiconductor substrate, forming a liner dielectric layer lining the trench, forming a buried contact in the trench, forming a buried power rail over and connected to the buried contact, wherein the buried power rail is between the two semiconductor strips, and forming isolation regions on opposite sides of the two semiconductor strips. The buried power rail is underlying a portion of the isolation regions. US 2020/105603 A1 discloses a method for forming a FinFET device structure includes forming a first fin structure and a second fin structure on a substrate. The method also includes depositing a first spacer layer over the first and second fin structures. The method also includes growing a power rail between the bottom portion of the first fin structure and the bottom portion of the second fin structure. The method also includes forming a second spacer layer over the sidewalls of the first spacer layer and over the top surface of the power rail. The method also includes forming a first fin isolation structure over the power rail between the first and second fin structures. The method also includes forming a first contact structure over the first fin structure and a portion of the power rail. The method also includes forming a second contact structure over the second fin structure. US 2020/135578 A1 discloses an integrated circuit with an interconnect structure that includes a buried interconnect conductor and a method for forming the integrated circuit are provided herein. In some examples, the method includes receiving a substrate that includes a plurality of fins extending from a remainder of the substrate. A spacer layer is formed between the plurality of fins, and a buried interconnect conductor is formed on the spacer layer between the plurality of fins. A set of capping layers is formed on the buried interconnect conductor between the plurality of fins. A contact recess is etched through the set of capping layers that exposes the buried interconnect conductor, and a contact is formed in the contact recess that is electrically coupled to the buried interconnect conductor.

However, there exist limitations associated with use of buried power rails in semiconductor devices. As an example, power strapping to the high-aspect ratio buried power rail requires a high-aspect ratio via to be connected to the buried power rail. Since such a via has high resistance, there would be considerable IR-drop in the power strap connection, which would make power delivery from the buried power rail to other parts of the semiconductor devices ineffective. Moreover, as large currents flow through this via to the nano-sized semiconductor devices, electromigration starts to adversely affect reliability of such devices.

Therefore, in light of the foregoing discussion there exists a need to overcome the aforementioned drawbacks associated with conventional semiconductor devices having buried power rails.

### SUMMARY

The present disclosure seeks to provide a semiconductor device, a semiconductor die, and a method of manufacturing a semiconductor device. The present disclosure seeks to provide a solution to the existing problems of power delivery inefficiency due to high IR-drop in power strap connections to buried power rails, and electromigration in semiconductor devices employing buried power rails. An aim of the present disclosure is to provide a solution that overcomes at least partially the problems encountered in prior art and provide an improved semiconductor device that has an efficient power delivery system from the buried rail and high electromigration resistance.

The object of the present disclosure is achieved by the solutions provided in the enclosed independent claims. Advantageous implementations of the present disclosure are further defined in the dependent claims.

In one aspect, the present disclosure provides a semiconductor device. The semiconductor devices comprises a substrate having thereon one or more active regions and a power rail located in an isolation trench in the device. The active region extends further from the substrate than the power rail. The semiconductor device further comprises one or more source/drain (S/D) contacts having a top wall extending along a surface of the active region facing away from the substrate and a side wall extending along a surface of the active region on the same side as the power rail but farther from the substrate. The semiconductor device being comprises a via trench adjacent to the side wall. The via trench includes a via which is on a first side in electrical contact with a surface of the power rail facing away from the substrate and on another side, perpendicular to the first side, conformal to and in electrical contact with the side wall of the S/D contact.

The self-aligned via contacting scheme employed in the semiconductor device enables significant reduction of resistance of the via that connects the one or more S/D contacts to the power rail. A large conformal contact surface of the via is formed at the contact interfaces of one or more sidewalls of the one or more S/D contacts, and a top surface of the power rail. In other words, the via is conformally self-aligned to the one or more S/D contacts and the power rail. Such an arrangement of the via enables efficient power delivery from the power rail to various regions of the semiconductor device, due to reduction of IR drop upon reduction of via resistance. Moreover, when current passes through the via, current density at said contact surface is considerably reduced due to large surface area. This, in turn, effectively mitigates electromigration within the semiconductor device and improves reliability of the semiconductor device. Moreover, the semiconductor device also allows a better process margin for an opening of the via because of significant reduction of aspect ratio for the via. This increased process margin reduces the risk of void formation at the via during the electroplating and/or any other metallization fill process.

In an implementation form, the semiconductor device comprises an active region on each side of the power rail, each active region having an S/D contact having a top wall extending along a surface facing away from the substrate and a side wall extending along a surface of the active region facing the power rail, wherein the via is in electrical contact with the power rail and the side walls of both S/D contacts.

By conformally contacting the via to the side walls of both S/D contacts and the power rail, there is enabled significant reduction of resistance of the via. This, in turn significantly reduces IR drop in the power strap configuration for efficient power delivery from the power rail. Moreover, in such a semiconductor device, electromigration is also mitigated effectively.

In a further implementation form, the semiconductor device comprises an active region on each side of the power rail, each active region having an S/D contact having a top wall extending along a surface facing away from the substrate and a side wall extending along a surface of the active region facing the power rail, wherein the via is in electrical contact with the power rail and the side wall of one of the S/D contacts, the side wall of the other S/D contact being separated from the via by a spacer element of insulating material.

By conformally contacting the via to only one of the side walls of the two S/D contacts and the power rail, there is enabled reduction of resistance of the via. This, in turn reduces IR drop in the power strap configuration for efficient power delivery from the power rail. Moreover, in such a semiconductor device, electromigration is also mitigated effectively. Such a via contacting scheme allows for selective contacting of the via with only some of S/D contacts, whilst electrically isolating the via with other S/D contacts.

In a further implementation form, the semiconductor device further comprises a metal to diffusion - MD - layer covering at least a portion of a surface of the via and a portion of the surface of the S/D contact facing away from the substrate.

The MD layer forms a power strap configuration along with the via for efficient and effective delivery of power from the power rail within the semiconductor device.

In another aspect, the present disclosure provides a semiconductor die piece comprises one or more semiconductor devices. The semiconductor die piece further comprises one or more second type devices. Each second type device comprises an active region and a power rail located in an isolation trench in the second type device. The active region extends further from a substrate than the power rail. Said second type device further comprises an S/D contact having a top wall extending along a surface of the active region facing away from the substrate and a side wall extending along a surface of the active region on the same side as the power rail but farther from the substrate. Each second type device also comprises a trench adjacent to the side wall. Said trench includes a region of insulating material adjacent to the side wall, or a via which is on a first side in electrical contact with a surface of the power rail facing away from the substrate and on another side, perpendicular to the first side, in electrical contact with the side wall of the S/D contact.

The semiconductor die piece can be effectively customized to obtain optimized advantages of both the one or more semiconductor devices and the one or more second type devices. Different portions of the semiconductor die piece may require different via landing solutions or non-via landing, which can be provided using the one or more semiconductor devices and the one or more second type devices.

In yet another aspect, the present disclosure provides a method of manufacturing a semiconductor device. The method comprises providing a substrate having one or more active regions, a power rail in an isolation trench with an insulating area between the power rail and the active region, and one or more source/drain (S/D) contacts having a top wall extending along a surface of the active region facing away from the substrate and a side wall extending along a surface of the active region on the same side as the power rail but farther from the substrate, the device having a via trench adjacent to the side wall. The method further comprises providing a via on a surface of the power rail facing away from the substrate in such a way that the via is on a first side in electrical contact with the power rail and on another side, perpendicular to the first side, conformal to and in electrical contact with the side wall of the S/D contact.

The method described herein is simple and easy to implement. The method enables manufacturing of semiconductor devices that include buried power rails and also facilitate efficient power delivery from the buried power rails. The low-resistance via power strap connection to the buried power rails enables effective delivery of power with minimal IR drop. Moreover, the semiconductor device manufactured by the method has high electromigration immunity

In an implementation form, the method comprises the steps, before providing the via, of providing a spacer element adjacent to the side wall of the S/D contact by conformal deposition, and selectively etching at least a portion of the spacer element to enable the via to be provided in the desired position.

Implementing such steps before providing the via enable the via to be efficiently provided at a required position within the semiconductor device. The via thus provided is well aligned to and in conformal contact with one or more S/D contacts in the semiconductor device, and with the power rail.

In a further implementation form, the method comprises the steps, before providing the via, of applying a spacer element adjacent to the side wall of the S/D contact by conformal deposition on the surface of the power rail facing away from the substrate, selectively etching at least a portion of the spacer element to form a via trench in an oxide layer, said via trench being open to the power rail and the side wall of the S/D contact, and applying the via in the trench.

By implementing such steps before providing the via, the via is efficiently provided in a required via trench within the semiconductor device. The via applied to the via trench is well aligned to and conforms well with the surfaces of the power rail and the one or more S/D contact that are open to the via trench.

In a further implementation form, the method comprises the step of applying a mask on the oxide layer before etching, so that a part of the oxide layer will remain, forming an insulating area between the via and another area of the device.

By virtue of applying the mask on the oxide layer before etching, selective etching of the oxide layer is performed, as required, to form the insulating area at a required region in the semiconductor device. The insulating area thus formed provides electrical isolation between the via and another area of the device.

In a further implementation form, the power rail is formed by: forming the isolation trench, depositing a spacer on at least one side of the isolation trench to separate the power rail from the one or more active regions, and applying a metal for the power rail in the remaining portion of the isolation trench.

Such a manner of forming the power rail enables formation of the power rail whilst ensuring effective electrical isolation between the power rail and the one or more active regions.

It will be appreciated that all implementation forms discussed hereinabove can be combined. It has to be noted that all devices, elements, circuitry, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof. It will be appreciated that features of the present disclosure are susceptible to being combined in various combinations without departing from the scope of the present disclosure as defined by the appended claims.

Additional aspects, advantages, features and objects of the present disclosure would be made apparent from the drawings and the detailed description of the illustrative implementations construed in conjunction with the appended claims that follow.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers.

Embodiments of the present disclosure will now be described, by way of example only, with reference to the following diagrams wherein:
FIG. 1A is a cross-sectional view of a semiconductor device, in accordance with an embodiment of the present disclosure;
FIG. 1B is a cross-sectional view of a semiconductor device, in accordance with another embodiment of the present disclosure;
FIG. 2 is a block architecture diagram of a semiconductor die piece, in accordance with an embodiment of the present disclosure;
FIG. 3A is a cross-sectional view of a second type device, in accordance with an embodiment of the present disclosure;
FIG. 3B is a cross-sectional view of a second type device, in accordance with another embodiment of the present disclosure;
FIG. 4 illustrates steps of a method of manufacturing a semiconductor device, in accordance with an embodiment of the present disclosure;
FIGs. 5A, 5B, and 5C illustrate cross-sectional views corresponding to various stages during manufacturing of a semiconductor device, in accordance with an embodiment of the present disclosure; and
FIGs. 6A, 6B, 6C, 6D, and 6E illustrate cross-sectional views corresponding to various stages during manufacturing of a semiconductor device, in accordance with another embodiment of the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practicing the present disclosure are also possible.

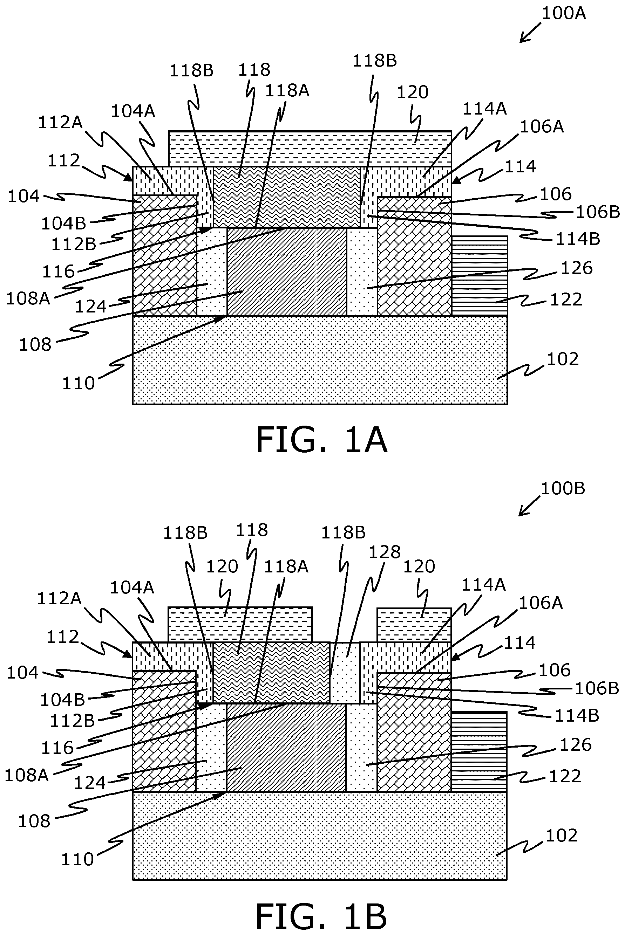

FIG. 1A is a cross-sectional view of a semiconductor device, in accordance with an embodiment of the present disclosure. With reference to FIG. 1A, there is shown a cross-sectional view of a semiconductor device **100A** that comprises a substrate **102** having thereon one or more active regions (depicted as two active regions **104** and **106**) and a power rail **108** located in an isolation trench **110** in the device **100A** (i.e. the semiconductor device **100A**), said device **100A** further comprising one or more source/drain (S/D) contacts (depicted as two S/D contacts **112** and **114**) having a top wall (depicted as top walls **112A** and **114A**) extending along a surface of the active region (depicted as surfaces **104A** and **106A** of the active regions **104** and **106,** respectively) facing away from the substrate **102** and a side wall (depicted as side walls **112B** and **114B**) extending along a surface of the active region (depicted as surfaces **104B** and **106B** of the active regions **104** and **106,** respectively) on the same side as the power rail 108 but farther from the substrate 102. The active regions **104** and **106** extend further from the substrate **102** than the power rail **108.** The semiconductor device **100A** also comprises a via trench **116** adjacent to the side walls **112B** and **114B,** said trench **116** including a via **118** which is on a first side **118A** in electrical contact with a surface **108A** of the power rail **108** facing away from the substrate **102** and on another side **118B,** perpendicular to the first side **118A,** conformal to and in electrical contact with the side walls **112B** and **114B** of the S/D contacts **112** and **114,** respectively. In an implementation, the semiconductor device **100A** is shown to further comprise a metal to diffusion - MD - layer **120,** a Shallow Trench Isolation (STI) portion **122,** and spacers **124** and **126** on two sides of the isolation trench **110** to separate the power rail **108** from the active regions **104** and **106.**

In an embodiment (shown, for example, in FIG. 1A), the semiconductor device **100A** comprises an active region on each side of the power rail **108** (depicted as the active regions **104** and **106** on left and right sides of the power rail **108**), each active region **104** and **106** having an S/D contact (depicted as the S/D contacts **112** and **114** corresponding to the active regions **104** and **106,** respectively) having a top wall **112A** and **114A** extending along a surface (depicted as the surfaces **104A** and **106A** of the active regions **104** and **106,** respectively) facing away from the substrate **102** and a side wall **112B** and **114B** extending along a surface (depicted as the surfaces **104B** and **106B** of the active regions **104** and **106,** respectively) facing the power rail **108,** wherein the via **118** is in electrical contact with the power rail **108** and the side walls **112B** and **114B** of both S/D contacts **112** and **114.**

It will be appreciated that in the aforesaid embodiment, there is provided a large contact surface for the via **118** between both:
- the first side **118A** (of the via **118**) and the surface **108A** (i.e. the top surface) of the power rail **108,** and
- the sides **118B** (of the via **118**) and the side walls **112B** and **114B** of both S/D contacts **112** and **114.**

Beneficially, provisioning of the large contact surface area by contacting the via **118** to both the side walls **112B** and **114B** and the power rail **108** enables significant reduction of resistance of the via **118.** This low-resistance via **118,** alongwith the MD layer **120,** forms an efficient power strap configuration (having a low IR drop) within the semiconductor device **100A.** This enables, in the semiconductor device **100A,** an effective delivery of power from the power rail **108.** As the large contact surface of the via **118** is provided, current density at a contact interface of said contact surface area is reduced, thereby, effectively mitigating electromigration within the semiconductor device **100A.** Such a manner of conformally contacting the via **118** provides an increased process margin for an opening of the via **118.**

FIG. 1B is a cross-sectional view of a semiconductor device, in accordance with another embodiment of the present disclosure. FIG. 1B is described in conjunction with elements of FIG. 1A. With reference to FIG. 1B, there is shown a cross-sectional view of a semiconductor device **100B** that additionally comprises a spacer element **128** of insulating material (in addition to elements depicted in the semiconductor device **100A** of FIG. 1A). The semiconductor device **100B** comprises the substrate **102** having thereon the one or more active regions **104** and **106** and the power rail **108** located in the isolation trench **110** in the device **100B** (i.e. the semiconductor device **100B**), the one or more source/drain (S/D) contacts **112** and **114** having the top walls **112A** and **114A** extending along the surfaces **104A** and **106A** (of the active regions **104** and **106,** respectively) facing away from the substrate **102** and the side walls **112B** and **114B** extending along the surfaces **104B** and **106B** (of the active regions **104** and **106,** respectively) on the same side as the power rail **108** but farther from the substrate **102.** The active regions **104** and **106** extend further from the substrate **102** than the power rail **108.** The semiconductor device **100B** also comprises the via trench **116** adjacent to the side walls **112B** and **114B,** said trench **116** including the via **118** which is on the first side **118A** in electrical contact with the surface **108A** of the power rail **108** facing away from the substrate **102** and on another side **118B,** perpendicular to the first side **118A,** conformal to and in electrical contact with the side walls **112B** and **114B** of the S/D contacts **112** and **114,** respectively. In an implementation, the semiconductor device **100B** is shown to further comprise the metal to diffusion - MD - layer **120,** the Shallow Trench Isolation (STI) portion **122,** and the spacers **124** and **126** on two sides of the isolation trench **110** to separate the power rail **108** from the active regions **104** and **106.**

In an embodiment (depicted, for example, in FIG. 1B), the semiconductor device **100B** comprises an active region on each side of the power rail **108** (depicted as the active regions **104** and **106** on left and right sides of the power rail **108**), each active region **104** and **106** having an S/D contact (depicted as the S/D contacts **112** and **114** corresponding to the active regions **104** and **106,** respectively) having a top wall **112A** and **114A** extending along a surface (depicted as the surfaces **104A** and **106A** of the active regions **104** and **106,** respectively) facing away from the substrate **102** and a side wall **112B** and **114B** extending along a surface **104B** and **106B** of the active region **104** and **106,** respectively, facing the power rail 108, wherein the via **118** is in electrical contact with the power rail 108 and the side walls **112B** of one (notably, the S/D contact **112**) of the S/D contacts **112** and **114,** the side wall **114B** of the other S/D contact **114** being separated from the via **118** by a spacer element **128** of insulating material.

In the aforesaid embodiment, the spacer element **128** of insulating material provides electrical isolation between the via **118** and the S/D contact **114.** The insulating material of the spacer element **128** is any suitable dielectric material such as, but not limited to, silicon dioxide (SiO2), silicon oxynitride (SiOxNy), and silicon nitride (Si3N4). The spacer element **128** of insulating material may simply be referred to as a "spacer" or a "dielectric spacer".

It will be appreciated that in the aforesaid embodiment, there is provided a large contact surface for the via **118** between both:
- the first side **118A** (of the via **118**) and the surface **108A** (i.e. the top surface) of the power rail **108,** and
- the side **118B** (of the via **118**) and the side wall **112B** of the S/D contact **112.**

Such a via contacting scheme allows for selective contacting of the via with only some of S/D contacts, whilst electrically isolating the via with other S/D contacts.

Beneficially, provision of said large contact surface area by contacting the via **118** to both the side wall **112B** and the power rail **108** enables significant reduction of resistance of the via **118.** This low-resistance via **118,** alongwith the MD layer **120,** forms an efficient power strap configuration (having a low IR drop) within the semiconductor device **100B.** This enables, in the semiconductor device **100B,** an effective delivery of power from the power rail **108.** As the large contact surface of the via **118** is provided, current density at a contact interface of said contact surface area is reduced, thereby, effectively mitigating electromigration within the semiconductor device **100B.** Such a manner of conformally contacting the via **118** provides an increased process margin for an opening of the via **118.**

It may be understood by a person skilled in the art that the FIGs. 1A and 1B include simplified exemplary illustrations of semiconductor devices **100A** and **100B** for sake of clarity, only, which should not unduly limit the scope of the claims herein. The person skilled in the art will recognize many variations, alternatives, and modifications of embodiments of the present disclosure.

The semiconductor device (for example, such as the semiconductor device **100A** or the semiconductor device **100B**) is an advanced semiconductor device (namely, an advanced semiconductor node). The semiconductor device **100A, 100B** is of the order of a couple of nanometers (nm). Optionally, the semiconductor device **100A, 100B** is usable in semiconductor manufacturing technologies of 22 nm and beyond. In this regard, the semiconductor device **100A, 100B** is usable, for example, in semiconductor manufacturing technologies of 22 nm, 14 nm, 10 nm, 7 nm, 5 nm, 3 nm, and beyond. More optionally, the semiconductor device **100A, 100B** is usable in semiconductor manufacturing technologies of 2 nm and beyond. As an example, the semiconductor device **100A, 100B** may be a 2nm semiconductor device.

In an embodiment, the semiconductor device **100A, 100B** is a fin field-effect transistor (FinFET) device. When the FinFET device is on, current flows from a source to a drain, a gate being wrapped around multiple sides (for example, three sides) of source/drain fin channel. Such an arrangement of the gate around the channel allows for greater control of the current flow within the channel. In another embodiment, the semiconductor device **100A, 100B** is a Gate-All-Around field-effect transistor (GAAFET) device. In the GAAFET device, a gate surrounds all four sides of a current channel between source and drain, thereby providing even greater control of current flow within the current channel than FinFET devices. In the GAAFET device, the current channel is formed using one or more nanowires or nanosheets coupling the source and the drain. It will be appreciated that in either of these embodiments, the semiconductor device **100A, 100B** is a non-planar transistor, namely, a three-dimensional transistor.

It will be appreciated that the semiconductor device **100A, 100B** finds use in a number of applications, for example, such as in processors, memory, or any other devices that rely on advanced technology nodes.

The substrate **102** is a base upon which various semiconductor device elements are fabricated or attached. The substrate **102** may be crystalline, semi-crystalline, microcrystalline, or amorphous. Moreover, a material of the substrate **102** may be a single un-doped element, a single doped element, a compound, or a combination of both semiconductor material and insulator materials. Examples of the material of the substrate 102 include, but are not limited to, monocrystalline silicon (Si), doped Si, Germanium (Ge), Silicon-Germanium (Si-Ge), a silicon-on-insulator (SOI), a III-V compound semiconductor material (for example, Gallium Arsenide - GaAs), a II-V compound semiconductor material. It will be appreciated that the substrate **102** is not limited to any particular structure, underlying layer and/or overlying layer, design, or material, but is contemplated to have any suitable structure, any combination of layers, any design or any material. References in the description to any particular types of substrates are for illustrative purposes only.

A given active region (such as the active regions **104** and **106**) is a region of the substrate **102** on which circuitry (namely, circuit components) is to be placed. In some implementations, a given semiconductor device has a single active region, whereas in other implementations, a given semiconductor device (for example, such as the semiconductor device **100A** or **100B**) has a plurality of active regions (such as the active regions **104** and **106).** It will be appreciated that when the given semiconductor device has the plurality of active regions, the plurality of active regions are electrically isolated from one another.

It will be appreciated that an "active region" may also be referred to as an "oxide diffusion - OD - region" or an "oxide definition - OD region". Notably, the one or more active regions **104** and **106** may comprise a source region (namely, a source diffusion region) or a drain region (namely, a drain diffusion region) of a transistor. The one or more active regions **104** and **106** may be doped with impurities to create, in the substrate **102,** a well having a net negative or net positive charge. The one or more active regions **104** and **106** are electrically active regions of the semiconductor device **100A, 100B.**

The power rail **108** enables power delivery to the semiconductor device **100A, 100B.** The circuitry of the semiconductor device (for example, the semiconductor device **100A, 100B**) requires power for operation, and this power is delivered from a power source to the circuitry, via the power rail **108.** The power rail **108** is located in the isolation trench **110,** and therefore can also be commonly referred to as a "buried power rail", a "buried rail", and the like. Provision of the power rail **108** in the isolation trench **110** enables reduction of power rail estate on the semiconductor device **100A, 100B,** thereby enabling shrinkage of size of the semiconductor device **100A, 100B.** It will be appreciated that an aspect ratio of the power rail **108** is selected as one which satisfies required resistance specifications of the power rail **108.**

Notably, the active regions **104** and **106** extend further from the substrate **102** than the power rail **108.** In other words, height of the active regions **104** and **106** is greater than height of the power rail **108.** Notably, the surfaces **104A** and **106A** (i.e. top surfaces) of the active regions **104** and **106,** respectively, are farther away from the substrate **102** as compared to the surface **108A** (i.e. top surface) of the power rail **108.** The power rail **108** is buried deep within the substrate **102,** in the isolation trench **110.** The depth of the power rail **108** within the substrate **102** is dependent at least on a required aspect ratio of the power rail **108.** In an embodiment, bottom surfaces of the power rail **108** and the one or more active regions **104** and **106** lie at a same or substantially a same layer.

In an embodiment, the one or more active regions **104** and **106** comprise source and drain terminals of the semiconductor device **100A, 100B.**

The source/drain-S/D-contacts **112** and **114** serve as source/drain electrical junctions at the semiconductor device **100A, 100B** as conductive carriers are either introduced to or are removed from a conductive channel of the semiconductor device **100A, 100B** through the S/D contacts **112** and **114.** The source and drain terminals of the semiconductor device **100A, 100B** are electrically connected to the power rail **108** through the S/D contacts **112** and **114.** The S/D contacts **112** and **114** electrically connect the power rail **108** to the active regions **104** and **106.**

In an embodiment, the one or more source/drain contacts **112** and **114** are epitaxy contacts. In such an embodiment, the source/drain contacts **112** and **114** are epitaxially grown on both the surfaces **104A** and **106A,** and the surfaces **104B** and **106B** of the active regions **104** and **106.** In another embodiment, the one or more source/drain contacts **112** and **114** are Wrap Around Contacts (WAC). In such an embodiment, the S/D contacts **112** and **114** wrap around the active regions **104** and **106,** respectively. In particular, the top walls **112A** and **114A** wrap around the surfaces **104A** and **106A** of the active regions **104** and **106,** respectively, whereas the side walls **112B** and **114B** wrap around the surfaces **104B** and **106B** of the active regions **104** and **106,** respectively.

In an embodiment, the one or more source/drain contacts (for example, such as the S/D contacts **112** and **114**) are made of a material including, but not limited to, Titanium (Ti), and Titanium Nitride (TiN).

The top walls **112A** and **114A** of the S/D contacts **112** and **114,** respectively, extend along the surfaces **104A** and **106A** of the active regions **104** and **106,** respectively, facing away from the substrate **102.** A top wall of a given S/D contact is a top portion of the given S/D contact that faces away from the substrate **102.** The side walls **112B** and **114B** of the S/D contacts **112** and **114,** respectively, extend along the the surfaces **104B** and **106B** of the active regions **104** and **106,** respectively, on the same side as the power rail **108** but farther from the substrate **102.** A side wall of a given S/D contact is a side portion of the given S/D contact, said side portion extending along a surface of a given active region that extends further from the substrate **102** than the power rail **108.** It will be appreciated that providing both the top wall and the side wall for each S/D contact enables provision of a greater S/D contact surface.

The semiconductor device **100A, 100B** comprises the via trench **116.** The via trench **116** is a trench in the semiconductor device **100A, 100B** that is dedicatedly employed to provide the via **118** in the semiconductor device **100A, 100B.** The via **118,** also known as vertical interconnect access (VIA) (or a "tap"), is an electrical connection between different portions of the semiconductor device **100A, 100B.** In particular, the via **118** is employed for efficiently and robustly delivering power from the power rail **108** to the different portions of the semiconductor device **100A, 100B,** as required. The via **118** ensures power delivery with reduced IR-drop and better electromigration immunity in the semiconductor device **100A, 100B.** In FIGs. 1A and 1B, the via **118** is shown to extend between the power rail 108 and the S/D contacts **112** and **114.** It will be appreciated that in the semiconductor device **100A, 100B,** the increased width of the via trench **116,** enables better process control margin for the via **118** opening due to significant reduction of aspect ratio for the via **118.** Provision of the via **118,** as described herein, is a self-aligned conformal via contacting scheme within the semiconductor device **100A,100B** that is isolated from adjacent unconnected semiconductor devices.

It will be appreciated that the via **118** is made of a conductive material or an alloy of the conductive material. Examples, of the conductive material include, but are not limited to, copper, aluminum, nickel, tungsten, cobalt, ruthenium, molybdenum, and palladium.

The STI portion **122** is formed in the semiconductor device **100A, 100B** to reduce leakage currents between an active region (such as the active region **106**) of the semiconductor device **100A, 100B,** and an active region of another device (which may be same as or may be different from the semiconductor device **100A, 100B**). The STI portion **122** is formed in the semiconductor device **100A, 100B** by creating a trench in the substrate **102,** and filling the trench with a dielectric material (for example, such as silicon dioxide, silicon nitride, and the like).

In an embodiment, the semiconductor device **100A, 100B** comprises at least one spacer (shown as the spacers **124** and **126**) on at least one side of the isolation trench 110. Optionally, in this regard, the at least one side of the isolation trench **110** is that which is adjacent to the one or more active regions **104** and **106.** The spacers **124** and **126** on two sides of the isolation trench **110** electrically separate the power rail **108** from the active regions **104** and **106.** In other words, the spacers **124** and **126** provide electrical isolation between the power rail **108** (in the isolation trench **110**) and the one or more active regions **104** and **106.** It will be appreciated that the at least one spacer (for example, such as the spacers **124** and **126**) are made of any suitable dielectric material such as, but not limited to, silicon dioxide (SiO2), silicon oxynitride (SiOxNy), and silicon nitride (Si3N4). The "spacer" may also be referred to commonly as "spacer element of insulating material" or a "dielectric spacer".

It will be appreciated that a material of the at least one spacer (such as the spacers **124** and **126**) on the at least one side of the isolation trench **110** could be same as or different from the insulating material of the spacer element **128** that separates a side wall of a given S/D contact (such as the side wall **114B** of the S/D contact **114**) from the via **118.**

In an embodiment, the semiconductor device **100A, 100B** further comprises the metal to diffusion - MD - layer **120** covering at least a portion of a surface of the via **118** and a portion of a surface of the S/D contact **112** and **114** facing away from the substrate **102.** The MD layer **120** forms a power strap configuration along with the via **118** for efficient and effective delivery of power from the power rail **108** within the semiconductor device **100A, 100B.** Herein, the MD layer **120** is a metal-to-diffusion layer (namely, a metal layer to a diffusion layer) that lies between a metal layer M0 and a diffusion layer of the semiconductor device **100A, 100B.** It will be appreciated that the semiconductor device **100A, 100B** may comprise a plurality of metal layers to allow interconnections between its active elements. In such a case, a number of the metal layers is selected as required, wherein M0 is the lowest metal layer amongst the plurality of metal layers and M0 is closest to the diffusion layer.

According to an embodiment depicted in FIG. 1A, the MD layer **120** covers an entirety of a top surface of the via **118,** a portion (depicted, for example, as a right portion) of a top surface of the S/D contact **112,** and an entirety of a top surface of the S/D contact **114.** According to another embodiment depicted in FIG. 1B, the MD layer **120** covers only select portions of the top surface of the via **118,** the top surface of the S/D contact **112,** and the top surface of the S/D contact **114.** Herein, a "top surface" of a given element (such as the via **118** and the S/D contacts **112** and **114**) refers to a surface of the given element that faces away from the substrate **102.**

Optionally, the MD layer **120** is made of a conductive metal material. As an example, the MD layer is made of a tungsten material.

It will be appreciated that detection of the aforesaid self-aligned conformal via contacting scheme of the via **118** in a given semiconductor device may be performed using a cross-sectional Transmission electron microscopy (TEM) technique combined with an elemental analysis technique (for example, such as Energy Dispersive X-Ray Spectroscopy (EDS)). The aforesaid techniques enable detection of side contact of the via **118** to the S/D contacts **112** and **114,** as well as bottom contact of the via **118** to the power rail **108.**

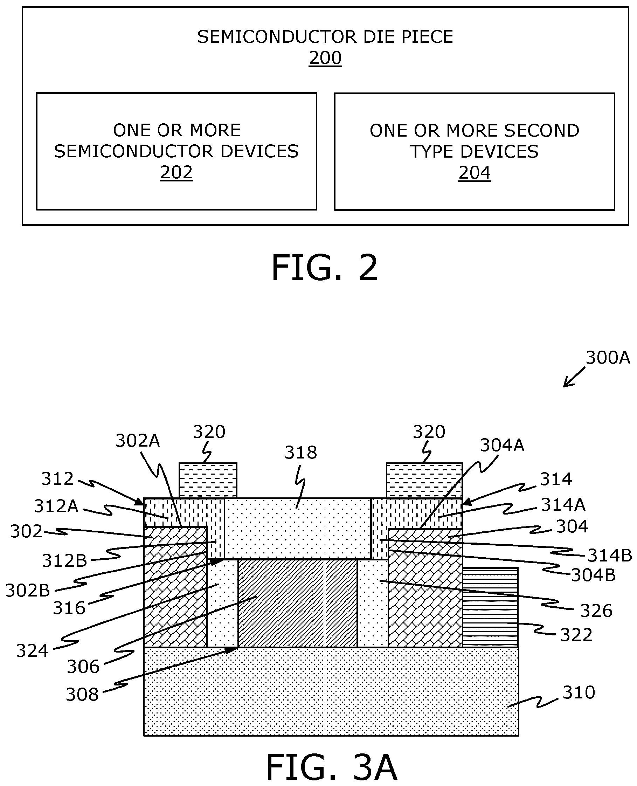

FIG. 2 is a block architecture diagram of a semiconductor die piece, in accordance with an embodiment of the present disclosure. With reference to FIG. 2, there is shown a block architecture diagram of semiconductor die piece **200** that comprises one or more semiconductor devices **202,** further comprising one or more second type devices **204.**

It may be understood by a person skilled in the art that the FIG. 2 depicts a simplified block architecture diagram of a semiconductor die piece **200** for sake of clarity, only, which should not unduly limit the scope of the claims herein. The person skilled in the art will recognize many variations, alternatives, and modifications of embodiments of the present disclosure. For example, the semiconductor die piece **200** could comprise a plurality of semiconductor devices and a plurality of second type devices.

The one or more semiconductor devices of the semiconductor die piece **200** are, for example, semiconductor devices such as the semiconductor device **100A** or the semiconductor device **100B.** Such semiconductor devices may be understood to be "first type devices". The one or more second type devices may be same as, or different from the one or more first type devices. Any number, configuration, or arrangement of the semiconductor devices and/or the second type devices may be used in the semiconductor die piece **200,** as required.

Optionally, in the semiconductor die piece **200,** the one or more semiconductor devices **202** and the one or more second type devices **204** are integrated on a common substrate to obtain optimized advantages of both these different types of devices **202** and **204** for different applications. Some portions of the semiconductor die piece **200** provide a via landing solution (for example, such as the portions corresponding to the one or more semiconductor devices **202**), whereas some portions of the semiconductor die piece **200** provide a non-via landing solution (for example, such as the portions corresponding to the one or more second type devices **204**). Therefore, the semiconductor die piece **200** can be customized as per requirement, and manufactured accordingly.

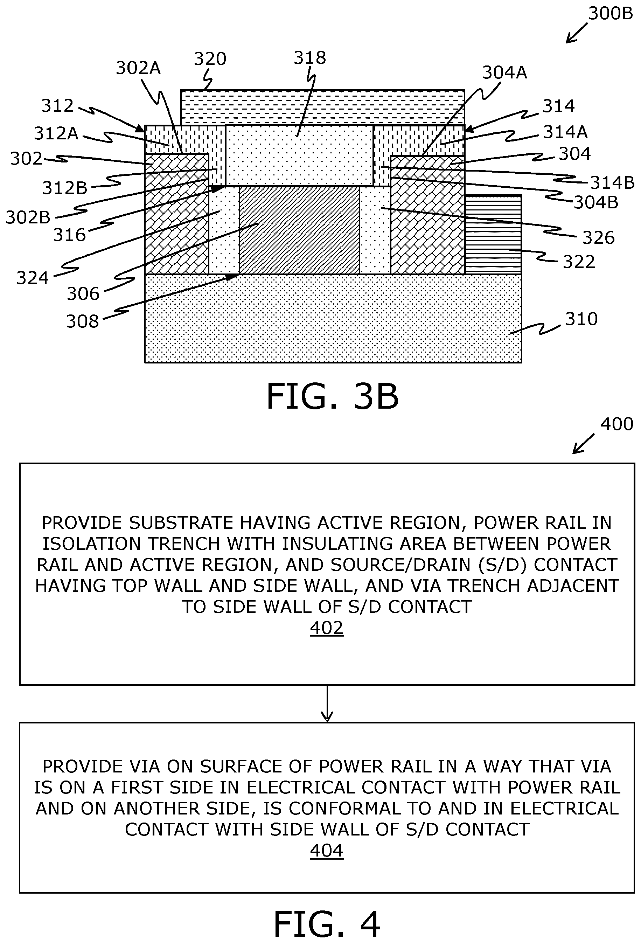

FIG. 3A is a cross-sectional view of a second type device, in accordance with an embodiment of the present disclosure. FIG. 3B is a cross-sectional view of a second type device, in accordance with another embodiment of the present disclosure. With reference to both FIG. 3A and FIG. 3B, the second type device (i.e. the second type device **300A** and the second type device **300B**) comprises an active region (depicted as active regions **302** and **304**) and a power rail **306** located in an isolation trench **308** in the second type device **300A, 300B,** the active region **302** and **304** extending further from a substrate **310** than the power rail **306,** said second type device **300A, 300B** further comprising an S/D contact (depicted as S/D contacts **312** and **314**) having a top wall (depicted as top walls **312A** and **314A**) extending along a surface (depicted as surfaces **302A** and **304A**) of the active region **302** and **304** facing away from the substrate **310** and a side wall (depicted as side walls **312B** and **314B**) extending along a surface (depicted as surfaces **302B** and **304B**) of the active region **302** and **304** on the same side as the power rail **306** but farther from the substrate **310.** The second type device **300A, 300B** also comprises a trench **316** adjacent to the side wall **312B** and **314B,** said trench **316** including a region **318** of insulating material adjacent to the side walls **312B** and **314B,** or a via (not shown) which is on a first side in electrical contact with a surface of the power rail **306** facing away from the substrate **310** and on another side, perpendicular to the first side, in electrical contact with the side walls **312B** and **314B** of the S/D contacts **312** and **314.** The second type device **300A, 300B** is shown to further comprise a metal to diffusion - MD - layer **320,** a Shallow Trench Isolation (STI) portion **322,** and spacers **324** and **326** on two sides of the isolation trench **308** to separate the power rail **306** from the active regions **302** and **304.**

It will be appreciated that several components of the second type device (i.e. the second type device **300A** of FIG. 3A and the second type device **300B** of FIG. 3B) correspond to components of the semiconductor device (i.e. the semiconductor device **100A** of FIG. 1A and the semiconductor device **100B** of FIG. 1B). Notably, the substrate **310,** the active regions **302** and **304,** the S/D contacts **312** and **314,** the power rail **306,** the MD layer **320,** the STI portion **322,** and the spacers **324** and **326,** of the second type device **300A, 300B** correspond to the substrate **102,** the active regions **104** and **106,** the S/D contacts **112** and **114,** the power rail **108,** the MD layer **120,** the STI portion **122,** and the spacers **124** and **126,** of the semiconductor device **100A, 100B,** respectively. For sake of brevity, these components have not been described again in the description.

In some embodiments, the trench **316** includes the region **318** of insulating material adjacent to the side wall **312B** and **314B.** Such exemplary embodiments are depicted, for example, in FIGs. 3A and 3B. It will be appreciated that providing the insulating material (for example, such as SiO2, SiOxNy, Si3N4, and the like) in the region **318** of the trench **316** provides the non-via landing solution in the semiconductor die piece **200.** In such a case, there is absence of via, and the insulating material lands fully within the region **318.** It will be appreciated that second type devices of such embodiments may be selected for further processing (for example, such as landing the via in at least a portion of the region **318**) to provide the via landing solution, if required.

In other embodiments, the trench **316** includes the via (not shown). In such embodiments, the via is in electrical contact with both the power rail **306** and the S/D contacts **312** and **314.**

FIG. 4 illustrates steps of a method of manufacturing a semiconductor device, in accordance with an embodiment of the present disclosure. With reference to FIG. 4, illustrated are steps of a method **400** of manufacturing a semiconductor device, in accordance with an embodiment of the present disclosure. The method **400** is employed to manufacture, for example, the semiconductor devices **100A** and **100B** described in FIG. 1A and FIG. 1B, respectively. The method **400** includes steps **402** and **404.**

At a step **402,** a substrate is provided. The substrate has one or more active regions, a power rail in an isolation trench with an insulating area between the power rail and the active region, and one or more source/drain - S/D - contacts having a top wall extending along a surface of the active region facing away from the substrate and a side wall extending along a surface of the active region on the same side as the power rail but farther from the substrate, the device having a via trench adjacent to the side wall.

At a step **404,** a via is provided on a surface of the power rail facing away from the substrate in such a way that the via is on a first side in electrical contact with the power rail and on another side, perpendicular to the first side, conformal to and in electrical contact with the side wall of the S/D contact.

The steps **402,** and **404** are only illustrative and other alternatives can also be provided where one or more steps are added, one or more steps are removed, or one or more steps are provided in a different sequence without departing from the scope of the claims herein.

The method **400** described herein is simple and easy to implement. The method **400** enables manufacturing of semiconductor devices that include buried power rails and also facilitate efficient power delivery from the buried power rails. The low-resistance via power strap connection to the buried power rails enables effective delivery of power with minimal IR drop. Moreover, the semiconductor device manufactured by the method **400** has high electromigration immunity.

In an embodiment, the step **402** of providing the substrate comprises:
- obtaining the substrate;
- defining the one or more active regions on the substrate;
- forming the power rail in the substrate; and
- forming the one or more source/drain-S/D-contacts.

In an embodiment, obtaining the substrate encompasses at least one of the steps of: procuring the substrate, cleaning the substrate, chemically treating the substrate.

According to an embodiment, defining the one or more active regions on the substrate comprises the steps of performing shallow trench isolation (STI) to make one or more trenches in the substrate, filling the one or more trenches with an oxide material, performing a planarization procedure to obtain a flat surface topology of the one or more trenches. For example, the oxide material may be a chemical vapor deposition (CVD) oxide material. According to another embodiment, defining the one or more active regions on the substrate comprises performing local oxidation of silicon (LOCOS).

In an embodiment, the power rail is formed by
forming the isolation trench,
depositing a spacer on at least one side of the isolation trench to separate the power rail from the one or more active regions, and
applying a metal for the power rail in the remaining portion of the isolation trench.

It will be appreciated that such a manner of forming the power rail enables formation of the power rail whilst ensuring effective electrical isolation between the power rail and the one or more active regions.

In an embodiment, the formation of the power rail further comprises performing a chemical mechanical planarization (CMP) process to planarize a top surface of the metal for the power rail.

In an embodiment, forming the isolation trench comprises anisotropic etching a portion of the substrate. The anisotropic etching is performed until an intended depth of the isolation trench is reached. The anisotropic etching is performed in a direction normal to the substrate.

In an embodiment, the spacer is conformally deposited on the at least one side of the isolation trench to separate the power rail from the one or more active regions. Moreover, in an embodiment, the spacer that is deposited on at least one side of the isolation trench is made of a dielectric material. Examples of the dielectric material include, but are not limited to, silicon dioxide (SiO₂), silicon oxynitride (SiOₓN_{y}), and silicon nitride (Si₃N₄). It will be appreciated that the deposited spacer forms an insulating area between the power rail and the one or more active regions.

In an embodiment, applying the metal for the power rail comprises depositing the metal (for the power rail) in the remaining portion (namely, the portion that is remaining after deposition of the spacer) of the isolation trench. Applying the metal for the power rail may also be referred to as "metallization of the power rail". It will be appreciated that the metal for the power rail may be a pure metal, or a metal alloy. Examples of the metal for the power rail include, but are not limited to, ruthenium, cobalt and tungsten.

In an embodiment, forming the one or more source/drain-S/D-contacts comprises epitaxially growing a required material (for example, Si, Ge, SiGe, and the like) on both a top surface, and a side surface of the one or more the active regions. In another embodiment, forming the one or more source/drain-S/D-contacts further comprises depositing a metal material (for example, titanium) on the epitaxial growth to form wrap around contacts.

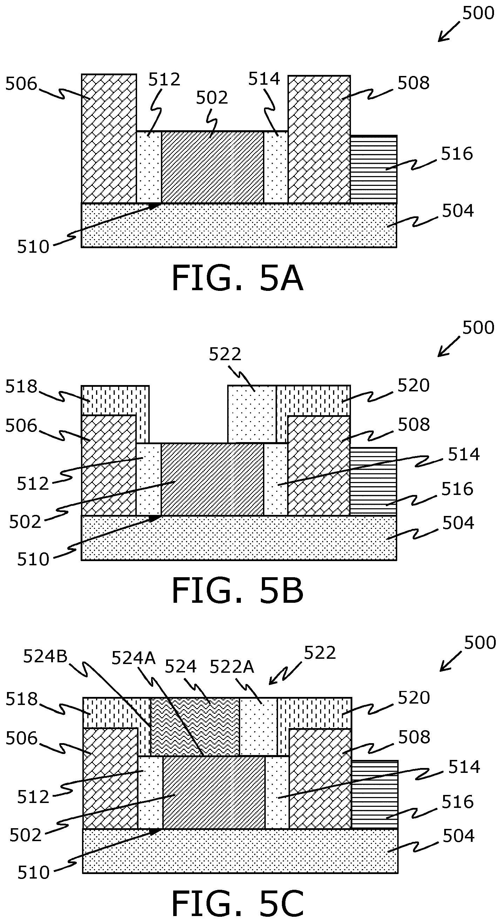

FIGs. 5A, 5B, and 5C illustrate cross-sectional views corresponding to various stages during manufacturing of a semiconductor device, in accordance with an embodiment of the present disclosure. With reference to FIGs. 5A-5C, there are illustrated cross-sectional views corresponding to various stages during manufacturing of a semiconductor device **500.**

With reference to FIG. 5A, there is shown a stage after formation of a power rail **502** in the semiconductor device **500.** At this stage, there is provided a substrate **504** having one or more active regions (depicted as active regions **506** and **508**). There is also shown an isolation trench **510,** spacers **512** and **514** on two sides of the isolation trench **510** to separate the power rail **502** from the one or more active regions **506** and **508.** At this stage, the power rail **502** is metallized. Additionally, there is also shown a Shallow Trench Isolation (STI) portion **516.**

With reference to FIG. 5B, there is shown a stage before providing a via (shown in FIG. 5C). At this stage, one or more source/drain-S/D-contacts (depicted as S/D contacts **518** and **520**) and a spacer element **522** are also shown to be formed on the semiconductor device **500,** in addition to the elements already formed in FIG. 5A. In an embodiment, the method comprises the steps, before providing the via, of providing a spacer element (i.e. the spacer element **522**) adjacent to the side wall of the S/D contact (i.e. the S/D contact **520**) by conformal deposition, and selectively etching at least a portion of the spacer element **522** to enable the via to be provided in the desired position. Implementing such steps before providing the via enable the via to be efficiently provided at a required position within the semiconductor device. The stage depicted in FIG. 5B occurs prior to said selective etching of the spacer element **522.**

In an embodiment, the method further comprises, prior to providing the spacer element **522** adjacent to the side wall of S/D contact **520** by conformal deposition, performing oxide trench etching using a mask (for example, such as a VB mask or a VB oxide etch mask). In such an embodiment, the mask may be designed to enable etching of only oxides in the semiconductor device **500.** Upon performing the oxide trench etching, a portion of oxide (of the active regions **506** and **508**) across the semiconductor device **500** is etched away. As an example, a top portion of oxide (of the active regions **506** and **508**) may be etched away upon performing the oxide trench etching. Herein, the term "mask" refers to a selective patterning tool that comprises different portions having different properties to enable selective etching.

In an embodiment, providing the spacer element **522** using conformal deposition enables the spacer element **522** to conform to contours of the side wall of the S/D contact (such as the side wall of the S/D contact **520**).

With reference to FIG. 5C, there is shown a stage after providing a via **524** on a surface (notably, a top surface) of the power rail **502** facing away from the substrate **504** in such a way that the via **524** is on a first side **524A** in electrical contact with the power rail **502** and on another side **524B,** perpendicular to the first side **524A,** conformal to and in electrical contact with the side wall of the S/D contact **518.** The via **524** is provided in this desired position upon selectively etching the spacer element **522** in a manner that only a select portion **522A** of the spacer element **522** remains in conformal contact with the side wall of the S/D contact **520** after etching.

According to an embodiment, the selective etching of at least a portion of the spacer element **522** is performed in a manner that upon etching, a portion of the spacer element **522** remains in conformal contact with the side wall of the S/D contact **520.** According to another embodiment, an entirety of the spacer element **522** is etched in a manner that upon etching, no portion of the spacer element **522** remains in conformal contact with the side wall of the S/D contact **520.**

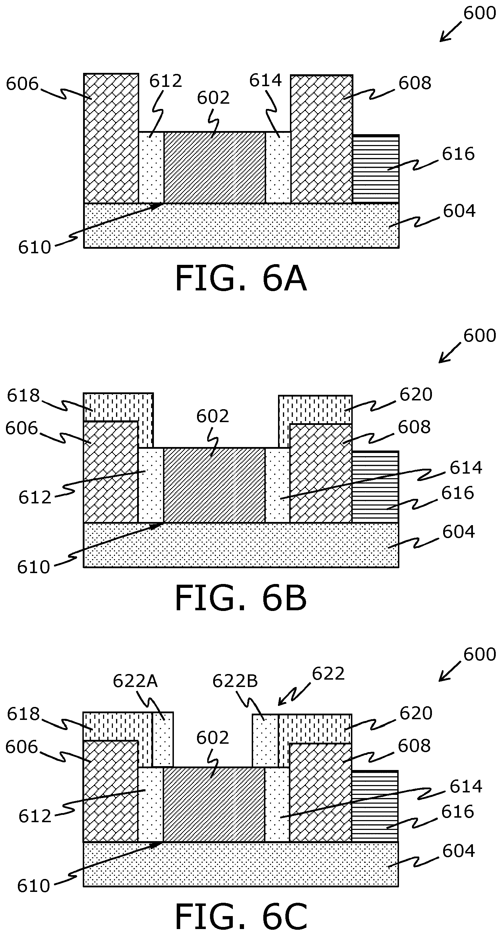

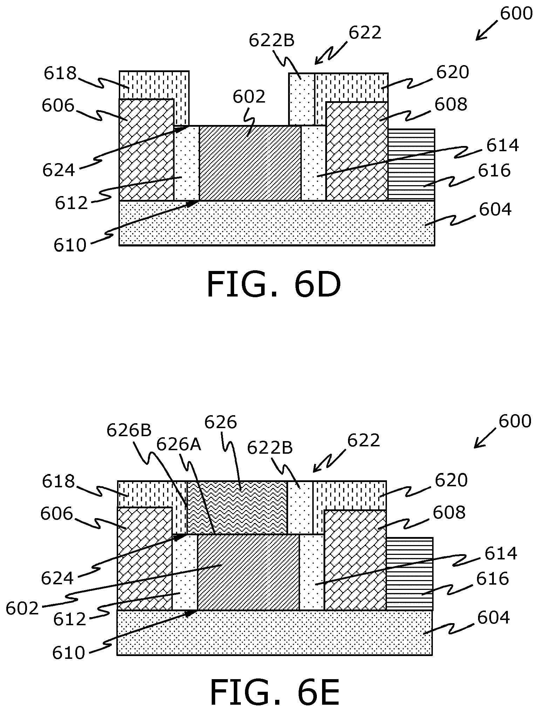

FIGs. 6A, 6B, 6C, 6D and 6E illustrate cross-sectional views corresponding to various stages during manufacturing of a semiconductor device, in accordance with another embodiment of the present disclosure. With reference to FIGs. 6A-6E, there are illustrated cross-sectional views corresponding to various stages during manufacturing of a semiconductor device **600.**

With reference to FIG. 6A, there is shown a stage after formation of a power rail **602** in the semiconductor device **600.** At this stage, there is provided a substrate **604** having one or more active regions (depicted as active regions **606** and **608**). There is also shown an isolation trench **610,** spacers **612** and **614** on two sides of the isolation trench **610** to separate the power rail **602** from the one or more active regions **606** and **608.** At this stage, the power rail **602** is metallized. Additionally, there is also shown a Shallow Trench Isolation (STI) portion **616.**

With reference to FIG. 6B, there is shown a stage after applying a mask (not shown) on an oxide layer (namely, an oxide definition layer comprising the active regions **606** and **608,** also known as oxide definition regions). The mask enables performing oxide trench etching in the semiconductor device **600.** At this stage, one or more source/drain-S/D-contacts (depicted as S/D contacts **618** and **620**) are also shown to be formed on the semiconductor device **600,** in addition to the elements already formed in FIG. 6A. In an embodiment, the method comprises the step of applying the mask on the oxide layer before etching, so that a part of the oxide layer will remain, forming an insulating area between the via (shown in FIG. 6E) and another area of the semiconductor device **600.** Such a step of applying the mask on the oxide layer before etching enables selective etching of the oxide layer, as required, to form the insulating area at a required region in the semiconductor device **600.** The insulating area thus formed provides electrical isolation between the via and the another area of the device. In this regard, the insulating area is optionally formed at least on top (namely, a top surface) of the remaining oxide layer. The insulating area is additionally, optionally, formed on a side (namely, a side surface) of the remaining oxide layer. In an embodiment, upon application of the mask (for example, such as a a VB mask or a VB oxide etch mask), the oxide layer is etched in a manner that after etching, only a part of the (original) oxide layer remains. As shown, for example in FIG. 6B, a top portion of the oxide layer is etched away, and a height of the active regions **606** and **608** in FIG. 6B is smaller than a height of the oxide layer in FIG. 6A.

With reference to FIG. 6C, there is shown an intermediate stage before providing a via (shown in FIG. 6E). At this stage, a spacer element **622** is also shown to be formed on the semiconductor device **600,** in addition to the elements already formed in FIG. 6B. In an embodiment, the method comprises the steps, before providing the via, of applying a spacer element (i.e. the spacer element **622**) adjacent to the side wall of the S/D contact (i.e. the S/D contacts **618** and **620**) by conformal deposition on the surface of the power rail **602** facing away from the substrate **604,** selectively etching at least a portion of the spacer element **622** to form a via trench (shown in FIG. 6D) in an oxide layer, said via trench being open to the power rail and the side wall of the S/D contact, and applying the via in the trench. Implementing such steps before providing the via enable the via to be efficiently provided in a required trench within the semiconductor device. FIG. 6C depicts the intermediate stage of the spacer element **622** as being applied adjacent to the side walls of both the S/D contacts **618** and **620** by the aforesaid conformal deposition. Notably, portions **622A** and **622B** of the spacer element **622** are applied adjacent to the side walls of the S/D contacts **618** and **620,** respectively.

With reference to FIG. 6D, there shown another intermediate stage before providing a via (shown in FIG. 6E). At this stage, which occurs after the selective etching of the spacer element **622,** there is shown only the portion **622B** of the spacer element **622** that remains upon selectively etching the portion **622A** of the spacer element. The portion **622A** is selectively etched, for example, by using a mask (such as VB.SPCCUT mask) that can be used to selectively remove the portion **622A** of the spacer element **622.** Such a manner of selective etching ensures that said mask can extend towards the S/D contact **618** in a manner that an entirety of the portion **622A** is etched away. The portion **622B** is shown to be immune to the etching (for example, due to initial spacer formation). In other words, the portion **622B** is overlay-insensitive to said mask used for selective etching, and therefore remains upon etching to provide a controlled spacer width from an isolating corner. At this stage, there is formed a via trench **624** that is open to the power rail **602** and the side wall of the S/D contact **618.**

Next, with reference to FIG. 6E, there is shown a stage after applying a via **626** in the via trench **624.** The via **626** is on a first side **626A** in electrical contact with the power rail **602** and on another side **626B,** perpendicular to the first side **626A,** conformal to and in electrical contact with the side wall of the S/D contact **618.** The selective etching of the portion **622A** enables metallization of the via in a manner that the side **626B** of the via **626** touches the side wall of the S/D contact **618,** and the first side **626A** of the via **626** touches the power rail **602.**

It will be appreciated that the aforesaid method of manufacturing the semiconductor device can be integrated in an overall process of manufacturing specialized semiconductor devices such as FinFET devices, GAAFET devices, and the like. One such example process of manufacturing said specialized semiconductor devices comprises:
- obtaining a substrate for fabrication of the semiconductor device thereon;
- forming a well and a ground plane in the substrate;
- epitaxially forming, on the substrate, an alternating arrangement of a silicon-germanium (SiGe) layer and a silion (Si) layer, when the specialized semiconductor device to be manufactured is a GAAFET device;
- defining the one or more active regions on the substrate using an active mask;
- patterning fins by employing an oxide definition mask;
- filling an oxide material in one or more trenches within the substrate;
- forming a first recess in a specific trench filled with the oxide material;
- forming the power rail;
- forming a dummy gate;
- performing source/drain extension implantation;
- depositing a spacer on the dummy gate;
- forming one or more source/drain - S/D - contacts;
- performing junction implantation for the one or more S/D contacts
- depositing inter layer dielectric zero (ILD0);
- removing the dummy gate;
- performing selective etching of sacrificial silicon-germanium (SiGe) layer(s) and silion (Si) layer(s), when the specialized semiconductor device to be manufactured is a GAAFET device;
- depositing high-k and metal-gate (HKMG) and conformally depositing work function (WF) metal;
- depositing a fill metal for gate;
- forming a recess in the fill mater for the gate;
- forming a Self-Aligned Contact (SAC) cap above the gate and performing a chemical mechanical planarization (CMP) process;
- providing a via; and
- performing Middle-Of-Line (MOL) and Back-End-Of-Line (BEOL) processes.

## Claims

1. A semiconductor device (100A, 100B, 202, 500, 600) comprising a substrate (102, 504, 604) having thereon one or more active regions (104, 106, 506, 508, 606, 608) and a power rail (108, 502, 602) located in an isolation trench (110, 510, 610) in the device (100A, 100B, 202, 500, 600), the active region (104, 106, 506, 508, 606, 608) extending further from the substrate (102, 504, 604) than the power rail (108, 502, 602), said device (100A, 100B, 202, 500, 600) further comprising one or more source/drain - S/D - contacts (112, 114, 518, 520, 618, 620) having a top wall (112A, 114A) extending along a surface (104A, 106A) of the active region (104, 106, 506, 508, 606, 608) facing away from the substrate (102, 504, 604) and a side wall (112B, 114B) extending along a surface (104B, 106B) of the active region (104, 106, 506, 508, 606, 608) on the same side as the power rail (108, 502, 602) but farther from the substrate (102, 504, 604), wherein the semiconductor device (100A, 100B, 202, 500, 600) comprises a via trench (116, 624) adjacent to the side wall (112B, 114B), said trench (116, 624) including a via (118, 524, 626) which is on a first side (118A, 524A, 626A) in electrical contact with a top surface (108A) of the power rail (108, 502, 602) facing away from the substrate (102, 504, 604) and on another side (118B, 524B, 626B), perpendicular to the first side (118A, 524A, 626A), conformal to and in electrical contact with the side wall (112B, 114B) of the S/D contact such that a conformal contact surface of the via is formed at the contact interface of only the side wall (112B, 114B) of the one or more S/D contacts (112, 114, 518, 520, 618, 620) and only the top surface (108A) of the power rail (108).

2. A semiconductor device (100A, 202) according to claim 1, comprising an active region (104, 106) on each side of the power rail (108), each active region (104, 106) having an S/D contact (112, 114) having a top wall (112A, 114A) extending along a surface (104B, 106B) facing away from the substrate (102) and a side wall (112B, 114B) extending along a surface (104B, 106B) of the active region (104, 106) facing the power rail (108), wherein the via (118) is in electrical contact with the power rail (108) and the side walls (112B, 114B) of both S/D contacts (112, 114) such that a conformal contact surface of the via is formed at the contact interfaces of only the side walls (112B, 114B) of each of the S/D contacts (112, 114, 518, 520, 618, 620) and only the top surface (108A) of the power rail (108).

3. A semiconductor device (100B, 202, 500, 600) according to claim 1, comprising an active region (104, 106, 506, 508, 606, 608) on each side of the power rail (108, 502, 602), each active region (104, 106, 506, 508, 606, 608) having an S/D contact (112, 114, 518, 520, 618, 620) having a top wall (112A, 114A) extending along a surface (104A, 106A) facing away from the substrate (102, 504, 604) and a side wall (112B, 114B) extending along a surface (104B, 106B) of the active region (104, 106, 506, 508, 606, 608) facing the power rail (108, 502, 602), wherein the via (118, 524, 626) is in electrical contact with the power rail (108, 502, 602)and the side wall (112B) of one of the S/D contacts (112, 518, 618), the side wall (114B) of the other S/D contact (114, 520, 620) being separated from the via (118, 524, 626) by a spacer element (128, 522, 622) of insulating material.

4. A semiconductor device (100A, 100B, 200, 500, 600) according to any one of the preceding claims, further comprising a metal to diffusion - MD - layer (120) covering at least a portion of a surface of the via (118, 524, 626) and a portion of the surface of the S/D contact (112, 114, 518, 520, 618, 620) facing away from the substrate (102, 504, 604).

5. A semiconductor die piece (200) comprising one or more semiconductor devices (202) according to any one of the preceding claims, further comprising one or more second type devices (204, 300A, 300B), each second type device comprising an active region (302, 304) and a power rail (306) located in an isolation trench (308) in the second type device (204, 300A, 300B), the active region (302, 304) extending further from a substrate (310) than the power rail (306), said second type device (204, 300A, 300B) further comprising an S/D contact (312, 314) having a top wall (312A, 312B) extending along a surface (302A, 304A) of the active region (302, 304) facing away from the substrate (310) and a side wall (312B, 314B) extending along a surface (302B, 304B) of the active region (302, 304) on the same side as the power rail (306) but farther from the substrate (310), each second type device (204, 300A, 300B) also comprising a trench (316) adjacent to the side wall (312B, 314B), said trench (316) including a region (318) of insulating material adjacent to the side wall (312B, 314B), or a via which is on a first side in electrical contact with a surface of the power rail (306) facing away from the substrate (310) and on another side, perpendicular to the first side, in electrical contact with the side wall of the S/D contact.

6. A method (400) of manufacturing a semiconductor device (100A, 100B, 202, 500, 600) according to claim 1, comprising the steps of
providing a substrate (102, 504, 604) having one or more active regions (104, 106, 506, 508, 606, 608), a power rail (108, 502, 602) in an isolation trench (110, 510, 610) with an insulating area between the power rail (108, 502, 602) and the active region (104, 106, 506, 508, 606, 608), and one or more source/drain - S/D - contacts (112, 114, 518, 520, 618, 620) having a top wall (112A, 114A) extending along a surface (104A, 106A) of the active region (104, 106, 506, 508, 606, 608) facing away from the substrate (102, 504, 604) and a side wall (112B, 114B) extending along a surface (104B, 106B) of the active region (104, 106, 506, 508, 606, 608) on the same side as the power rail (108, 502, 602) but farther from the substrate (102, 504, 604), the semiconductor device (100A, 100B, 202, 500, 600) having a via trench (116, 624) adjacent to the side wall (112B, 114B), the method comprising the steps of providing a via (118, 524, 626) on a surface (108A) of the power rail (108, 502, 602) facing away from the substrate (102, 504, 604) in such a way that the via (118, 524, 626) is on a first side (118A, 524A, 626A) in electrical contact with the power rail (108, 502, 602) and on another side (118B, 524B, 626B), perpendicular to the first side (118A, 524A, 626A), conformal to and in electrical contact with the side wall (112B, 114B) of the S/D contact such that a conformal contact surface of the via is formed at the contact interface of only the side wall (112B, 114B) of the one or more S/D contacts (112, 114, 518, 520, 618, 620) and only the top surface (108A) of the power rail (108).

7. A method (400) according to claim 6, comprising the steps, before providing the via (524), of providing a spacer element (522) adjacent to the side wall of the S/D contact (520) by conformal deposition, and selectively etching at least a portion of the spacer element (522) to enable the via (524) to be provided in the desired position.

8. A method (400) according to claim 6, comprising the steps, before providing the via (626), of applying a spacer element (622) adjacent to the side wall of the S/D contact (618, 620) by conformal deposition on the surface of the power rail (602) facing away from the substrate (604), selectively etching at least a portion (622A) of the spacer element (622) to form a via trench (624) in an oxide layer, said via trench (624) being open to the power rail (602) and the side wall of the S/D contact (618), and applying the via (626) in the trench (624).

9. A method (400) according to claim 8, comprising the step of applying a mask on the oxide layer before etching, so that a part of the oxide layer will remain, forming an insulating area between the via (626) and another area of the semiconductor device (600).

10. A method (400) according to any one of the claims 6 - 9, wherein the power rail (108, 502, 602) is formed by
forming the isolation trench (110, 510, 610),
depositing a spacer (124, 126, 512, 514, 612, 614) on at least one side of the isolation trench (110, 510, 610) to separate the power rail (108, 502, 602) from the one or more active regions (104, 106, 506, 508, 606, 608), and
applying a metal for the power rail (108, 502, 602) in the remaining portion of the isolation trench (110, 510, 610).

## Patentansprüche

1. Halbleitervorrichtung (100A, 100B, 202, 500, 600), umfassend ein Substrat (102, 504, 604) mit einer oder mehreren aktiven Regionen (104, 106, 506, 508, 606, 608) und einer Stromschiene (108, 502, 602) darauf, die sich in einem Isolationsgraben (110, 510, 610) in der Vorrichtung (100A, 100B, 202, 500, 600) befindet, wobei sich die aktive Region (104, 106, 506, 508, 606, 608) weiter weg von dem Substrat (102, 504, 604) erstreckt als die Stromschiene (108, 502, 602), wobei die Vorrichtung (100A, 100B, 202, 500, 600) ferner einen oder mehrere "Source-/Drain-", S/D-Kontakte (112, 114, 518, 520, 618, 620) umfasst, die eine obere Wand (112A, 114A) aufweisen, die sich entlang einer Oberfläche (104A, 106A) der aktiven Region (104, 106, 506, 508, 606, 608) erstreckt, die von dem Substrat (102, 504, 604) weg weist, und eine Seitenwand (112B, 114B), die sich entlang einer Oberfläche (104B, 106B) der aktiven Region (104, 106, 506, 508, 606, 608) auf der gleichen Seite wie die Stromschiene (108, 502, 602), jedoch weiter entfernt vom Substrat (102, 504, 604) erstreckt, wobei die Halbleitervorrichtung (100A, 100B, 202, 500, 600) einen Durchkontaktierungsgraben (116, 624) angrenzend an die Seitenwand (112B, 114B) umfasst, wobei der Graben (116, 624) eine Durchkontaktierung (118, 524, 626) beinhaltet, die an einer ersten Seite (118A, 524A, 626A) in elektrischem Kontakt mit einer Oberseite (108A) der Stromschiene (108, 502, 602) steht, die von dem Substrat (102, 504, 604) weg weist, und einer anderen Seite (118B, 524B, 626B) senkrecht zu der ersten Seite (118A, 524A, 626A), die konform zu der Seitenwand (112B, 114B) des S/D-Kontakts liegt und in elektrischem Kontakt mit dieser steht, so dass eine konforme Kontaktfläche der Durchkontaktierung an der Kontaktgrenzfläche nur der Seitenwand (112B, 114B) des einen oder der mehreren S/D-Kontakte (112, 114, 518, 520, 618, 620) und nur der Oberseite (108A) der Stromschiene (108) gebildet ist.

2. Halbleitervorrichtung (100A, 202) nach Anspruch 1, eine aktive Region (104, 106) an jeder Seite der Stromschiene (108) umfassend, wobei jede aktive Region (104, 106) einen S/D-Kontakt (112, 114) mit einer oberen Wand (112A, 114A) aufweist, die sich entlang einer Oberfläche (104B, 106B) erstreckt, die von dem Substrat (102) weg weist, und einer Seitenwand (112B, 114B), die sich entlang einer Oberfläche (104B, 106B) der aktiven Region (104, 106) erstreckt, die zu der Stromschiene (108) weist, wobei die Durchkontaktierung (118) in elektrischem Kontakt mit der Stromschiene (108) und den Seitenwänden (112B, 114B) beider S/D-Kontakte (112, 114) steht, so dass eine konforme Kontaktfläche der Durchkontaktierung an den Kontaktgrenzflächen nur der Seitenwände (112B, 114B) jedes der S/D-Kontakte (112, 114, 518, 520, 618, 620) und nur der Oberseite (108A) der Stromschiene (108) gebildet ist.

3. Halbleitervorrichtung (100B, 202, 500, 600) nach Anspruch 1, eine aktive Region (104, 106, 506, 508, 606, 608) an jeder Seite der Stromschiene (108, 502, 602) umfassend, wobei jede aktive Region (104, 106, 506, 508, 606, 608) einen S/D-Kontakt (112, 114, 518, 520, 618, 620) mit einer oberen Wand (112A, 114A) aufweist, die sich entlang einer Oberfläche (104A, 106A) erstreckt, die von dem Substrat (102, 504, 604) weg weist, und einer Seitenwand (112B, 114B), die sich entlang einer Oberfläche (104B, 106B) der aktiven Region (104, 106, 506, 508, 606, 608) erstreckt, die zu der Stromschiene (108, 502, 602) weist, wobei die Durchkontaktierung (118, 524, 626) in elektrischem Kontakt mit der Stromschiene (108, 502, 602) und der Seitenwand (112B) eines der S/D-Kontakte (112, 518, 618) steht, wobei die Seitenwand (114B) des anderen S/D-Kontakts (114, 520, 620) durch ein Abstandshalterelement (128, 522, 622) aus isolierendem Material von der Durchkontaktierung (118, 524, 626) getrennt ist.

4. Halbleitervorrichtung (100A, 100B, 202, 500, 600) nach einem der vorhergehenden Ansprüche, ferner eine Metalldiffusions-, MD-Schicht (120) umfassend, die mindestens einen Abschnitt einer Oberfläche der Durchkontaktierung (118, 524, 626) und einen Abschnitt der Oberfläche des S/D-Kontakts (112, 114, 518, 520, 618, 620), der von dem Substrat (102, 504, 604) weg weist, bedeckt.

5. Halbleiter-Nacktchip-Teil (200), eine oder mehrere Halbleitervorrichtungen (202) nach einem der vorhergehenden Ansprüche umfassend, ferner eine oder mehrere Vorrichtungen (204, 300A, 300B) zweiter Art umfassend, wobei jede Vorrichtung zweiter Art eine aktive Region (302, 304) und eine Stromschiene (306), die sich in einem Isolationsgraben (308) in der Vorrichtung (204, 300A, 300B) zweiter Art befindet, umfasst, wobei sich die aktive Region (302, 304) weiter weg von einem Substrat (310) als die Stromschiene (306) erstreckt, wobei die Vorrichtung (204, 300A, 300B) zweiter Art ferner einen S/D-Kontakt (312, 314) mit einer oberen Wand (312A, 312B) umfasst, die sich entlang einer Oberfläche (302A, 304A) der aktiven Region (302, 304) erstreckt, die von dem Substrat (310) weg weist, und eine Seitenwand (312B, 314B), die sich entlang einer Oberfläche (302B, 304B) der aktiven Region (302, 304) auf der gleichen Seite wie die Stromschiene (306), jedoch weiter von dem Substrat (310) weg erstreckt, wobei jede Vorrichtung (204, 300A, 300B) zweiter Art außerdem einen Graben (316) umfasst, der an die Seitenwand (312B, 314B) grenzt, wobei der Graben (316) eine Region (318) aus isolierendem Material angrenzend an die Seitenwand (312B, 314B) beinhaltet oder eine Durchkontaktierung, die sich an einer ersten Seite in elektrischem Kontakt mit einer Oberfläche der Stromschiene (306) befindet, die weg von dem Substrat (310) weist, und an der anderen Seite, senkrecht zu der ersten Seite, die in elektrischem Kontakt mit der Seitenwand des S/D-Kontakts steht.

6. Verfahren (400) zur Herstellung einer Halbleitervorrichtung (100A, 100B, 202, 500, 600) nach Anspruch 1, umfassend die Schritte des Bereitstellens eines Substrats (102, 504, 604) mit einer oder mehreren aktiven Regionen (104, 106, 506, 508, 606, 608), einer Stromschiene (108, 502, 602) in einem Isolationsgraben (110, 510, 610) mit einem Isolationsbereich zwischen der Stromschiene (108, 502, 602) und der aktiven Region (104, 106, 506, 508, 606, 608) und einem oder mehreren "Source-/Drain- ", S/D-Kontakten (112, 114, 518, 520, 618, 620), die eine obere Wand (112A, 114A) aufweisen, die sich entlang einer Oberfläche (104A, 106A) der aktiven Region (104, 106, 506, 508, 606, 608) erstreckt, die von dem Substrat (102, 504, 604) weg weist, und eine Seitenwand (112B, 114B), die sich entlang einer Oberfläche (104B, 106B) der aktiven Region (104, 106, 506, 508, 606, 608) auf der gleichen Seite wie die Stromschiene (108, 502, 602), jedoch weiter von dem Substrat (102, 504, 604) weg erstreckt, wobei die Halbleitervorrichtung (100A, 100B, 202, 500, 600) einen Durchkontaktierungsgraben (116, 624) angrenzend an die Seitenwand (112B, 114B) aufweist, wobei das Verfahren die Schritte des Bereitstellens einer Durchkontaktierung (118, 524, 626) auf einer Oberfläche (108A) der Stromschiene (108, 502, 602) umfasst, die von dem Substrat (102, 504, 604) weg weist, so dass die Durchkontaktierung (118, 524, 626) an einer ersten Seite (118A, 524A, 626A) in elektrischem Kontakt mit der Stromschiene (108, 502, 602) steht und an einer anderen Seite (118B, 524B, 626B), senkrecht zu der ersten Seite (118A, 524A, 626A), konform zu der Seitenwand (112B, 114B) des S/D-Kontakts liegt und in elektrischen Kontakt mit dieser steht, so dass eine konforme Kontaktfläche der Durchkontaktierung an der Kontaktgrenzfläche nur der Seitenwand (112B, 114B) des einen oder der mehreren S/D-Kontakte (112, 114, 518, 520, 618, 620) und nur der Oberseite (108A) der Stromschiene (108) gebildet wird.

7. Verfahren (400) nach Anspruch 6, vor dem Bereitstellen der Durchkontaktierung (524) die Schritte des Bereitstellens eines Abstandshalterelements (522) angrenzend an die Seitenwand des S/D-Kontakts (520) durch konformes Abscheiden und selektives Ätzen mindestens eines Abschnitts des Abstandshalterelements (522), um das Bereitstellen der Durchkontaktierung (524) an der gewünschten Position zu ermöglichen, umfassend.

8. Verfahren (400) nach Anspruch 6, vor dem Bereitstellen der Durchkontaktierung (626) die Schritte des Aufbringens eines Abstandshalterelements (622) angrenzend an die Seitenwand des S/D-Kontakts (618, 620) durch konformes Abscheiden auf der Oberfläche der Stromschiene (602), die von dem Substrat (604) weg weist, selektives Ätzen mindestens eines Abschnitts (622A) des Abstandshalterelements (622), um einen Durchkontaktierungsgraben (624) in einer Oxidschicht zu bilden, wobei der Durchkontaktierungsgraben (624) zu der Stromschiene (602) und der Seitenwand des S/D-Kontakts (618) offen ist, und des Aufbringens der Durchkontaktierung (626) in dem Graben (624) umfassend.

9. Verfahren (400) nach Anspruch 8, den Schritt des Aufbringens einer Maske auf der Oxidschicht vor dem Ätzen umfassend, so dass ein Teil der Oxidschicht zurückbleiben wird, was einen Isolationsbereich zwischen der Durchkontaktierung (626) und einem anderen Bereich der Halbleitervorrichtung (600) bildet.

10. Verfahren (400) nach einem der Ansprüche 6 bis 9, wobei die Stromschiene (108, 502, 602) gebildet wird durch
Bilden des Isolationsgrabens (110, 510, 610),
Abscheiden eines Abstandshalters (124, 126, 512, 514, 612, 614) auf mindestens einer Seite des Isolationsgrabens (110, 510, 610), um die Stromschiene (108, 502, 602) von der einen oder den mehreren aktiven Regionen (104, 106, 506, 508, 606, 608) zu trennen, und
Aufbringen eines Metalls für die Stromschiene (108, 502, 602) in dem verbliebenen Abschnitt des Isolationsgrabens (110, 510, 610).

## Revendications

1. Dispositif à semi-conducteur (100A, 100B, 202, 500, 600) comprenant un substrat (102, 504, 604) portant une ou plusieurs régions actives (104, 106, 506, 508, 606, 608) et un rail d'alimentation (108, 502, 602) situé dans une tranchée d'isolation (110, 510, 610) dans le dispositif (100A, 100B, 202, 500, 600), la région active (104, 106, 506, 508, 606, 608) s'étendant plus loin depuis le substrat (102, 504, 604) que le rail d'alimentation (108, 502, 602), ledit dispositif (100A, 100B, 202, 500, 600) comprenant en outre un ou plusieurs contacts source/drain, S/D, (112, 114, 518, 520, 618, 620) présentant une paroi supérieure (112A, 114A) s'étendant le long d'une surface (104A, 106A) de la région active (104, 106, 506, 508, 606, 608) orientée à l'opposé du substrat (102, 504, 604) et une paroi latérale (112B, 114B) s'étendant le long d'une surface (104B, 106B) de la région active (104, 106, 506, 508, 606, 608) du même côté que le rail d'alimentation (108, 502, 602) mais plus éloignée du substrat (102, 504, 604), le dispositif à semi-conducteur (100A, 100B, 202, 500, 600) comprenant une tranchée de via (116, 624) adjacente à la paroi latérale (112B, 114B), ladite tranchée (116, 624) comportant un via (118, 524, 626) qui est situé sur un premier côté (118A, 524A, 626A) en contact électrique avec une surface supérieure (108A) du rail d'alimentation (108, 502, 602) orientée à l'opposé du substrat (102, 504, 604) et sur un autre côté (118B, 524B, 626B), perpendiculaire au premier côté (118A, 524A, 626A), conforme et en contact électrique avec la paroi latérale (112B, 114B) du contact S/D de sorte qu'une surface de contact conforme du via est formée à l'interface de contact uniquement de la paroi latérale (112B, 114B) du ou des contacts S/D (112, 114, 518, 520, 618, 620) et uniquement de la surface supérieure (108A) du rail d'alimentation (108).

2. Dispositif à semi-conducteur (100A, 202) selon la revendication 1, comprenant une région active (104, 106) de chaque côté du rail d'alimentation (108), chaque région active (104, 106) présentant un contact S/D (112, 114) présentant une paroi supérieure (112A, 114A) s'étendant le long d'une surface (104B, 106B) orientée à l'opposé du substrat (102) et une paroi latérale (112B, 114B) s'étendant le long d'une surface (104B, 106B) de la région active (104, 106) orientée vers le rail d'alimentation (108), le via (118) étant en contact électrique avec le rail d'alimentation (108) et les parois latérales (112B, 114B) des deux contacts S/D (112, 114) de sorte qu'une surface de contact conforme du via est formée aux interfaces de contact uniquement des parois latérales (112B, 114B) de chacun des contacts S/D (112, 114, 518, 520, 618, 620) et uniquement de la surface supérieure (108A) du rail d'alimentation (108).

3. Dispositif à semi-conducteur (100B, 202, 500, 600) selon la revendication 1, comprenant une région active (104, 106, 506, 508, 606, 608) de chaque côté du rail d'alimentation (108, 502, 602), chaque région active (104, 106, 506, 508, 606, 608) présentant un contact S/D (112, 114, 518, 520, 618, 620) présentant une paroi supérieure (112A, 114A) s'étendant le long d'une surface (104A, 106A) orientée à l'opposé du substrat (102, 504, 604) et une paroi latérale (112B, 114B) s'étendant le long d'une surface (104B, 106B) de la région active (104, 106, 506, 508, 606, 608) orientée vers le rail d'alimentation (108, 502, 602), le via (118, 524, 626) étant en contact électrique avec le rail d'alimentation (108, 502, 602) et la paroi latérale (112B) de l'un des contacts S/D (112, 518, 618), la paroi latérale (114B) de l'autre contact S/D (114, 520, 620) étant séparée du via (118, 524, 626) par un élément espaceur (128, 522, 622) en matériau isolant.

4. Dispositif à semi-conducteur (100A, 100B, 200, 500, 600) selon l'une quelconque des revendications précédentes, comprenant en outre une couche métal-vers-diffusion, MD, (120) recouvrant au moins une portion d'une surface du via (118, 524, 626) et une portion de la surface du contact S/D (112, 114, 518, 520, 618, 620) orientée à l'opposé du substrat (102, 504, 604).

5. Puce à semi-conducteur (200) comprenant un ou plusieurs dispositifs à semi-conducteur (202) selon l'une quelconque des revendications précédentes, comprenant en outre un ou plusieurs dispositifs de deuxième type (204, 300A, 300B), chaque dispositif de deuxième type comprenant une région active (302, 304) et un rail d'alimentation (306) situé dans une tranchée d'isolation (308) dans le dispositif de deuxième type (204, 300A, 300B), la région active (302, 304) s'étendant plus loin depuis un substrat (310) que le rail d'alimentation (306), ledit dispositif de deuxième type (204, 300A, 300B) comprenant en outre un contact S/D (312, 314) présentant une paroi supérieure (312A, 312B) s'étendant le long d'une surface (302A, 304A) de la région active (302, 304) orientée à l'opposé du substrat (310) et une paroi latérale (312B, 314B) s'étendant le long d'une surface (302B, 304B) de la région active (302, 304) du même côté que le rail d'alimentation (306) mais plus éloignée du substrat (310), chaque dispositif de deuxième type (204, 300A, 300B) comprenant également une tranchée (316) adjacente à la paroi latérale (312B, 314B), ladite tranchée (316) comportant une région (318) en matériau isolant adjacente à la paroi latérale (312B, 314B), ou un via qui est situé sur un premier côté en contact électrique avec une surface du rail d'alimentation (306) orientée à l'opposé du substrat (310) et sur un autre côté, perpendiculaire au premier côté, en contact électrique avec la paroi latérale du contact S/D.

6. Procédé (400) de fabrication d'un dispositif à semi-conducteur (100A, 100B, 202, 500, 600) selon la revendication 1, comprenant les étapes suivantes
fourniture d'un substrat (102, 504, 604) présentant une ou plusieurs régions actives (104, 106, 506, 508, 606, 608), un rail d'alimentation (108, 502, 602) dans une tranchée d'isolation (110, 510, 610) avec une zone isolante entre le rail d'alimentation (108, 502, 602) et la région active (104, 106, 506, 508, 606, 608), et un ou plusieurs contacts source/drain, S/D, (112, 114, 518, 520, 618, 620) présentant une paroi supérieure (112A, 114A) s'étendant le long d'une surface (104A, 106A) de la région active (104, 106, 506, 508, 606, 608) orientée à l'opposé du substrat (102, 504, 604) et une paroi latérale (112B, 114B) s'étendant le long d'une surface (104B, 106B) de la région active (104, 106, 506, 508, 606, 608) du même côté que le rail d'alimentation (108, 502, 602) mais plus éloignée du substrat (102, 504, 604), le dispositif à semi-conducteur (100A, 100B, 202, 500, 600) présentant une tranchée de via (116, 624) adjacente à la paroi latérale (112B, 114B), le procédé comprenant l'étape de fourniture d'un via (118, 524, 626) sur une surface (108A) du rail d'alimentation (108, 502, 602) orientée à l'opposé du substrat (102, 504, 604), de manière à ce que le via (118, 524, 626) soit situé sur un premier côté (118A, 524A, 626A) en contact électrique avec le rail d'alimentation (108, 502, 602) et sur un autre côté (118B, 524B, 626B), perpendiculaire au premier côté (118A, 524A, 626A), conforme et en contact électrique avec la paroi latérale (112B, 114B) du contact S/D, de sorte qu'une surface de contact conforme du via est formée à l'interface de contact uniquement de la paroi latérale (112B, 114B) du ou des contacts S/D (112, 114, 518, 520, 618, 620) et uniquement de la surface supérieure (108A) du rail d'alimentation (108).

7. Procédé (400) selon la revendication 6, comprenant, avant la fourniture du via (524), les étapes de fourniture d'un élément espaceur (522) adjacent à la paroi latérale du contact S/D (520) par dépôt conforme, et de gravure sélective d'au moins une portion de l'élément espaceur (522) afin de permettre la fourniture du via (524) à la position souhaitée.

8. Procédé (400) selon la revendication 6, comprenant, avant la fourniture du via (626), les étapes d'application d'un élément espaceur (622) adjacent à la paroi latérale du contact S/D (618, 620) par dépôt conforme sur la surface du rail d'alimentation (602) orientée à l'opposé du substrat (604), de gravure sélective d'au moins une portion (622A) de l'élément espaceur (622) afin de former une tranchée de via (624) dans une couche d'oxyde, ladite tranchée de via (624) étant ouverte sur le rail d'alimentation (602) et sur la paroi latérale du contact S/D (618), et d'application du via (626) dans la tranchée (624).

9. Procédé (400) selon la revendication 8, comprenant l'étape d'application d'un masque sur la couche d'oxyde avant la gravure, de sorte qu'une partie de la couche d'oxyde subsiste, formant une zone isolante entre le via (626) et une autre zone du dispositif à semi-conducteur (600).

10. Procédé (400) selon l'une quelconque des revendications 6 à 9, dans lequel le rail d'alimentation (108, 502, 602) est formé par
la formation de la tranchée d'isolation (110, 510, 610),
le dépôt d'un élément espaceur (124, 126, 512, 514, 612, 614) sur au moins un côté de la tranchée d'isolation (110, 510, 610) afin de séparer le rail d'alimentation (108, 502, 602) de la ou des régions actives (104, 106, 506, 508, 606, 608), et
l'application d'un métal pour le rail d'alimentation (108, 502, 602) dans la portion subsistante de la tranchée d'isolation (110, 510, 610).
